# EUROPÄISCHE PATENTSCHRIFT

(11) **EP 1 784 110 B1**
(45) Veröffentlichungstag und Bekanntmachung des Hinweises auf die Patenterteilung: **22.10.2008**
(21) Anmeldenummer: 05777817.7
(22) Anmeldetag: 05.08.2005
(51) Int. Cl.: A47L 9/28, A47L 9/26

(54) **STAUBSAUGER MIT EINER SPANNUNGSFREI GEHALTENEN LEITERPLATTE**
VACUUM CLEANER WITH A PRINTED CIRCUIT BOARD THAT IS MOUNTED WITHOUT TENSION
ASPIRATEUR MUNI D'UNE CARTE A CIRCUITS IMPRIMES RETENUE SANS CONTRAINTE

(30) Priorität: 24.08.2004 DE 102004040986
(43) Veröffentlichungstag der Anmeldung: 16.05.2007
(73) Patentinhaber: BSH Bosch und Siemens Hausgeräte GmbH, 81739 München (DE)
(72) Erfinder: LEHMANN, Peter, 98617 Mainingen (DE); PÖTSCH, Thomas, 01945 Frauendorf (DE); SCHELER, Christian, 96528 Rauenstein (DE); SEITH, Thomas, 97616 Bad Neustadt (DE)
(86) Internationale Anmeldenummer: PCT/EP2005/053876
(87) Internationale Veröffentlichungsnummer: WO 2006/021501

(56) Entgegenhaltungen:
- DE-A1- 19 801 468
- DE-U1- 9 100 815
- PATENT ABSTRACTS OF JAPAN Bd. 016, Nr. 334 (C-0964), 21. Juli 1992 (1992-07-21) -& JP 04 097732 A (MATSUSHITA ELECTRIC IND CO LTD), 30. März 1992 (1992-03-30)

## Beschreibung

Die Erfindung betrifft einen Staubsauger mit einer Leiterplatte gemäß dem Oberbegriff des Patentanspruches 1.

Aus EP 365 797 B1 ist ein Staubsauger bekannt, bei dem die Leiterplatte an einem Tragteil angeordnet ist. Des Weiteren ist ein zum Ein-/Ausschalten des Gebläseaggregats dienender Schalter an dem Tragteil befestigt und mittels Stecklaschen mit den Leiterbahnen der Leiterplatte verbunden. Die Betätigung des Schalters erfolgt über eine Taste, die mittels eines Stößelansatzes auf den Schaltstößel des Schalters wirkt. Durch die Befestigung des Schalters am Tragteil werden die Betätigungskräfte von dem Tragteil aufgenommen, so dass die Leiterplatte von den Betätigungskräften nicht unmittelbar belastet wird. Nachteilig hierbei ist jedoch, dass die Leiterplatte an dem Tragteil angeordnet ist. Betätigungskräfte die in den Schalter eingeleitet werden, können zwar in das Tragteil eingeleitet werden, ohne unmittelbar auf die Leiterplatte einzuwirken, die in das Tragteil eingeleitete Betätigungskräfte können jedoch teilweise weiterhin auf die Leiterplatte übertragen werden, da diese weiterhin am Tragteil angeordnet ist. Nachteilig hierbei ist es, dass trotz Anwendung eines Tragteils für den Schalter Betätigungskräfte zumindest teilweise weiterhin auf die Leiterplatte übertragen werden.

Aufgabe der Erfindung ist es, die beim Betätigen des Schalters eingeleiteten Betätigungskräfte von der Leiterplatte fern zu halten.

Die erfindungsgemäße Aufgabe wird bei einem gattungsgemäßen Staubsauger dadurch gelöst, dass die Leiterplatte von der Halterung mechanisch getrennt an den elektrischen Kontakten des elektrischen Bauteils spannungsfrei gehalten ist. Indem die Halterung für das elektrische Bauteil von der Leiterplatte vollständig mechanisch getrennt wird, ist sichergestellt, dass keinerlei Betätigungskräfte auf die Leiterplatte übertragen werden. Durch die erfindungsgemäße Trennung von Halterung und Leiterplatte werden Beschädigungen der Leiterplatte bspw. aufgrund von Spannungsrissen vermieden und die Lebensdauer des Staubsaugers dadurch verlängert.

In einer bevorzugten Ausgestaltung der Erfindung weist die Halterung das elektrische Bauteil umgreifende Rasthaken auf, durch die das elektrische Bauteil in der Halterung gehalten ist. Mittels der an der Halterung vorgesehenen Rasthaken, kann das elektrische Bauteil vorzugsweise zusammen mit der Leiterplatte in die Halterung eingeschnappt werden und ist dort zuverlässig mechanisch gehalten, ohne gesonderte Befestigungsmittel vorsehen zu müssen. In einer ersten Variante der Erfindung ist die Halterung an einem Gehäuseteil des Staubsaugers vorgesehen. Das Gehäuseteil kann bspw. eine Trennwand zwischen einem Gebläseraum und einem Aufnahmeraum für eine Kabeltrommel sein. Bei der Montage wird dann das elektrische Bauteil, bspw. ein elektrischer Schalter zum Ein- und Ausschalten des Staubsaugers oder ein Potentiometer zum Regeln der Saugleistung des Staubsaugers in die Halterung am Gehäuse eingeschnappt. Durch das Befestigen bzw. Einschnappen des elektrischen Bauteils in die Halterung wird gleichzeitig die Leiterplatte im Staubsauger fixiert. Dabei ist das elektrische Bauteil mit der Leiterplatte lediglich über dessen elektrische Kontakte mechanisch verbunden. Da die Leiterplatte nur ein sehr geringes Gewicht aufweist und keinerlei weiteren mechanischen Belastungen ausgesetzt ist, kann die Leiterplatte in ausreichender Weise allein über die elektrischen Kontakte des elektrischen Bauteils im Staubsauger gehalten sein. Erfindungsgemäß bedarf es also keiner zusätzlichen mechanischen Befestigung mittels Halterungen oder Tragstrukturen um das elektrische Bauteil mit der Leiterplatte mechanisch zu verbinden. Erfindungsgemäß ergibt sich dabei auch der Vorteil, dass ein zusätzliches Haltemittel oder Tragmittel entbehrlich ist und somit die Teilezahl für den Staubsauger reduziert wird.

Alternativ kann in einer zweiten Variante die Halterung statt an einem Gehäuseteil an einer Tragstruktur einer im Gehäuse des Staubsaugers gelagerten Kabeltrommel vorgesehen sein. Analog der Befestigung des elektrischen Bauteils an der Halterung am Gehäuseteil kann das elektrische Bauteil, wie Schalter oder Potentiometer, in einer Halterung eingesetzt werden, die an der Tragstruktur einer Kabeltrommel vorgesehen ist. Die Tragstruktur bildet dabei einen Teil des feststehenden Teils der Kabeltrommel an dem bspw. der feststehende Lagerzapfen der drehbaren Trommel vorgesehen ist. Ein weiterer Vorteil der Halterung des elektrischen Bauteils an einer Tragstruktur der Kabeltrommel ist die Tatsache, dass das elektrische Bauteil zusammen mit der Leiterplatte an der Kabeltrommel vormoniert sein kann. Bei der endgültigen Montage des Staubsaugers muss dann nur die bereits vormonierte Kabeltrommel zusammen mit Leiterplatte und elektrischen Bauteilen in das Gehäuse des Staubsaugers eingesetzt werden. Besonders vorteilhaft ist es dabei, dass die elektrische Kontaktierung der Kabeltrommel an die Leiterplatte bereits bei der Vormontage von Leiterplatte und elektrischen Bauteilen an die Tragstruktur der Kabeltrommel erfolgen kann. Dabei kann bei der Endmontage des Staubsaugers ein zusätzlicher Schritt für die elektrische Kontaktierung der Kabeltrommel entfallen.

In einer weiterführenden Ausgestaltung der Erfindung kann die Leiterplatte mittels einer Abstützung gegen ungewolltes Bewegen der Leiterplatte in einer Bewegungsrichtung aus der Leiterplattenebene heraus gesichert sein. Zu beachten ist dabei, dass die Abstützung nicht dazu dient mechanische Kräfte, die über das elektrische Bauteil eingeleitet werden, aufzunehmen, sondern die Abstützung soll insbesondere so ausgestaltet sein, dass die Leiterplatte weiterhin spannungsfrei an dem elektrischen Bauteil nur über die elektrischen Kontakte gehalten ist. Die Abstützung soll vielmehr dazu dienen, dass unerwünschte Biegespannungen zwischen Leiterplatte und elektrischem Bauteil eingeleitet werden, welche zu Biegebeanspruchungen der elektrischen Kontakte des elektrischen Bauteils führen könnten. Durch die erfindungsgemäße Abstützung der Leiterplatte gegen ungewolltes Bewegen der Leiterplatte in einer Bewegungsrichtung aus der Leiterplattenebene heraus wird insbesondere ein Bruch der elektrischen Kontakte des elektrischen Bauteils zuverlässig verhindert.

Vorzugsweise ist die Abstützung an einem der Halterung gegenüberliegenden Ende der Leiterplatte vorgesehen. So kann sichergestellt werden, dass schon bei geringfügigen ungewünschten Bewegungen der Leiterplatte die Abstützung bereits wirksam wird und die Einleitung von Biegespannungen in die elektrischen Kontakte des elektrischen Bauteils frühzeitig verhindert werden.

In einer vorteilhaften Ausgestaltung der Erfindung ist die Abstützung als ein am Gehäuse des Staubsaugers oder an der Tragstruktur der Kabeltrommel vorgesehener, die Leiterplatte umgreifender, Rasthaken ausgebildet. Der Rasthaken liegt dabei nicht fest an der Leiterplatte an, sondern umgreift die Leiterplatte unter Bildung eines geringfügigen Spaltes, so dass keinerlei Spannungen in der Leiterplatte entstehen können.

Ein Ausführungsbeispiel der Erfindung ist in den Figuren 1 bis 3 näher erläutert. Es zeigen:
- Figur 1: einen Längsschnitt durch ein Gehäuseteil eines erfindungsgemäßen Staubsaugers;
- Figur 2: einen zweiten Längsschnitt durch das Gehäuseteil aus Figur 1 von gegenüberliegender Seite;
- Figur 3: eine perspektivische Ansicht auf eine erfindungsgemäße Kabeltrommel.

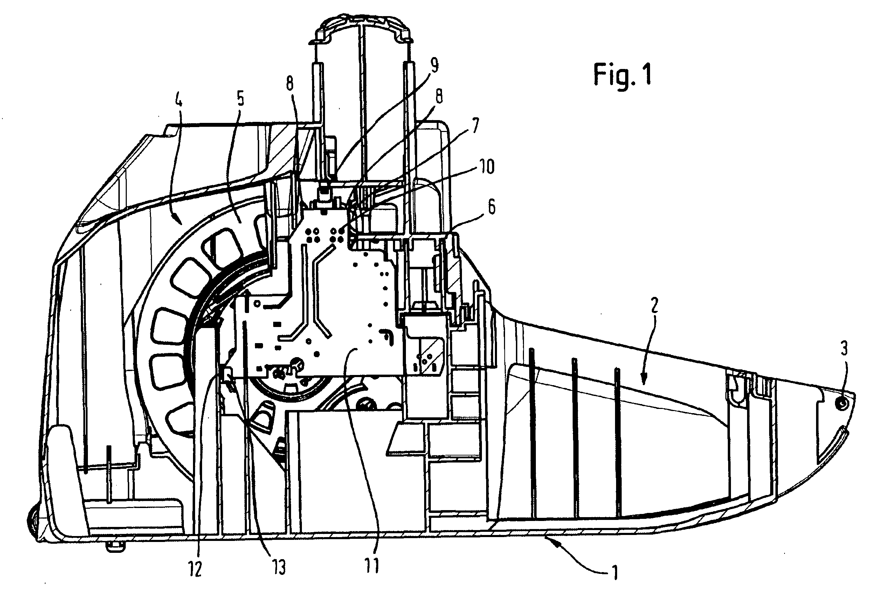

Ein Gehäuseteil 1 eines erfindungsgemäßen Staubsaugers ist in Figur 1 im Längsschnitt dargestellt. Das Gehäuseteil 1 weist im vorderen Bereich einen Staubraum 2 auf. In dem Staubraum 2 ist ein Staubfilterbeutel oder eine Staubsammelbox einsetzbar. Am vorderen Ende des Gehäuseteils 1 ist ein Scharnier 3 für einen nicht dargestellten schwenkbar am Gehäuseteil 1 zu befestigenden Staubraumdeckel vorgesehen. An dem Staubraum 2 schließt sich im hinteren Bereich des Staubsaugers an einem dem Scharnier 3 gegenüberliegenden Ende ein Aufnahmeraum 4 für eine Kabeltrommel 5 an. An einer Gehäusewand 6 des Gehäuseteils 1 ist eine Halterung 7 angeformt. Die Halterung 7 weist zwei gegenüberliegende Rasthaken 8 auf, die ein elektrisches Bauteil 9, nämlich einen Schalter, umgreifen. Das elektrische Bauteil bzw. der elektrische Schalter weist elektrische Kontakte 10 auf, die mit einer Leiterplatte 11 verbunden sind. Die Leiterplatte 11 hängt frei von den elektrischen Kontakten 10 nach unten in den Aufnahmeraum 4 hinein, ohne an einer weiteren Stelle des Gehäuseteils 1 befestigt zu sein. Lediglich an einer Seitenwand 12 des Gehäuseteils 1 ist eine Abstützung 13 vorgesehen, welche ein Schwenken der Leiterplatte aus der Zeichnungsebene heraus verhindert.

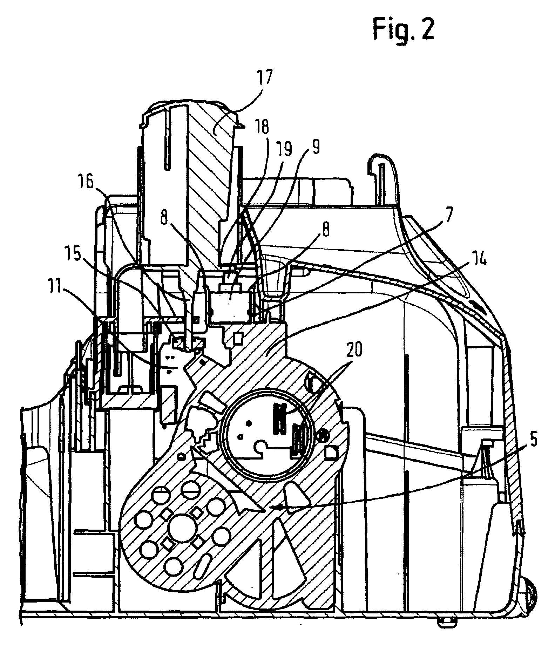

Analog der Figur 1 ist in Figur 2 die Leiterplatte 11 spannungsfrei an dem elektrischen Bauteil 9 gehalten. Die Halterung 7 ist an einer Tragstruktur 14 der Kabeltrommel 5 vorgesehen. Die Rasthaken 8 sind an die Tragstruktur 14 mitangeformt und umgreifen das elektrische Bauteil. Auf der Leiterplatte 11 ist des Weiteren ein Drehpotentiometer 15 befestigt. Das Potentiometer 15 wird durch eine Verstellwelle 16 betätigt, welche Verstellwelle 16 an einem Betätigungselement 17 angeformt. Das Betätigungselement 17 weist eine kreisscheibenförmige Bodenplatte 18 auf, welche auf einen Betätigungsstift 19 des elektrischen Schalters 9 drückt. Mittels des Betätigungselements 17 kann durch ein Drehen des Betätigungselements 17 die Leistung des Staubsaugers verstellt werden, indem die drehbewegliche Verstellwelle 16 das Potentiometer betätigt. Durch Drücken des Betätigungselements 17 wird durch Übertragung der Druckkraft von der Bodenplatte 18 auf den Betätigungsstift 19 des elektrischen Schalters 9 der Staubsauger ein- und ausgeschaltet. Bei der in Figur 2 gezeigten Lagerung des elektrischen Bauteils 9 an einer Halterung 7, welche an einer Tragstruktur 14 einer Kabeltrommel 5 vorgesehen ist, kann die Leiterplatte 11 zusätzlich direkt mit elektrischen Anschlüssen 20 elektrisch an die Kabeltrommel 5 kontaktiert sein.

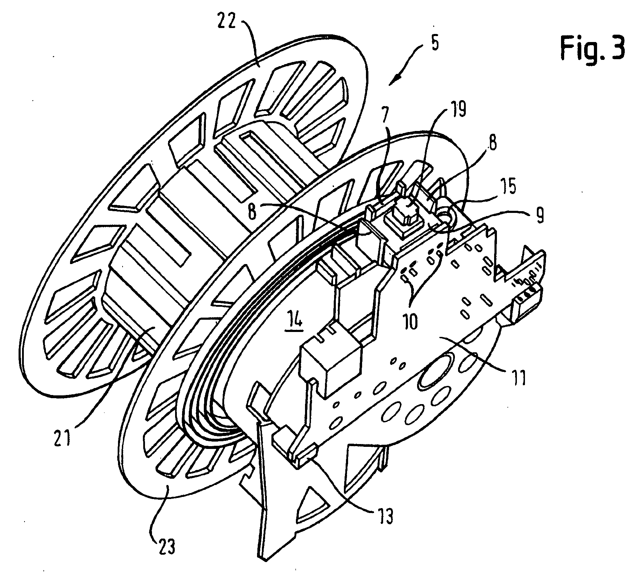

Die Variante gemäß Figur 2 ist in Figur 3 in perspektivischer Ansicht deutlicher dargestellt. Die Kabeltrommel 5 weist einen drehbar gelagerten Trommelkörper 21 auf. An den beiden gegenüberliegenden Enden des Trommelkörpers 21 ist ein äußerer Trommelflansch 22 und ein innerer Trommelflansch 23 mit dem Trommelkörper 21 verbunden. Der Trommelkörper 21 sitzt drehbar auf einem nicht dargestellten Lagerzapfen, der an der Tragstruktur 14 angeformt ist. An der Tragstruktur 14 ist die Halterung 7 angeformt. Die Halterung 7 umfasst zwei gegenüberliegende Rasthaken 8, welche den Schalter 9 umgreifen. Zum elektrischen Ein- und Ausschalten des elektrischen Schalters 9 weist dieser einen Betätigungsstift 19 auf. Über den Betätigungsstift 19 werden elektrische Kontakte geschlossen und geöffnet. Die elektrischen Kontakte 10 verbinden den Schalter 9 mit der Leiterplatte 11. An der Tragstruktur 14 ist des Weiteren die Abstützung 13 angeformt, welche als Sicherung für die Leiterplatte gegen Schwenken der Leiterplatte bildet. Neben dem Schalter 9 ist an der Leiterplatte 11 des Weiteren ein Potentiometer 15 elektrisch kontaktiert befestigt.

## Patentansprüche

1. Staubsauger mit einem Betätigungselement (17) für ein in einer Halterung (7) im Staubsauger befestigtes, elektrisches Bauteil (9), dessen elektrische Kontakte (10) auf einer Leiterplatte (11) mechanisch befestigt und zur Steuerung mindestens einer Funktion des Staubsaugers mit Leiterbahnen der Leiterplatte (11) elektrisch kontaktierend verbunden sind, **dadurch gekennzeichnet, dass** die Leiterplatte (11) von der Halterung (7) mechanisch getrennt an den elektrischen Kontakten (10) des elektrischen Bauteils (9) spannungsfrei gehalten ist.

2. Staubsauger nach Anspruch 1, **dadurch gekennzeichnet, dass** die Halterung (7) das elektrische Bauteil (9) umgreifende Rasthaken (8) aufweist, durch die das elektrische Bauteil (9) in der Halterung (7) gehalten ist.

3. Staubsauger nach Anspruch 1 oder 2, **dadurch gekennzeichnet, dass** die Halterung (7) an einem Gehäuseteil (1) des Staubsaugers vorgesehen ist.

4. Staubsauger nach Anspruch 1 oder 2, **dadurch gekennzeichnet, dass** die Halterung (7) an einer Tragstruktur (14) einer im Gehäuse des Staubsaugers gelagerten Kabeltrommel (5) vorgesehen ist.

5. Staubsauger nach einem der vorhergehenden Ansprüche, **dadurch gekennzeichnet, dass** die Leiterplatte (11) mittels einer Abstützung (13) gegen ungewolltes Bewegen der Leiterplatte (11) in einer Bewegungsrichtung aus der Leiterplattenebene heraus gesichert ist.

6. Staubsauger nach Anspruch 5, **dadurch gekennzeichnet, dass** die Abstützung (13) an einem der Halterung (7) gegenüberliegenden Ende der Leiterplatte (11) vorgesehen ist.

7. Staubsauger nach Anspruch 5 oder 6, **dadurch gekennzeichnet, dass** die Abstützung (13) als ein am Gehäuse des Staubsaugers oder an der Tragstruktur (14) der Kabeltrommel (5) vorgesehener, die Leiterplatte (11) umgreifender Rasthaken (8) ausgebildet ist.

## Revendications

1. Aspirateur comportant un élément d'actionnement (17) pour un composant électrique (9) fixé dans un dispositif de fixation (7) dans l'aspirateur et dont les contacts électriques (10) sont fixés mécaniquement sur une carte de circuits imprimés (11) et sont reliés en faisant contact électrique à des pistes conductrices de la carte de circuits imprimés (11) pour la commande d'au moins une fonction de l'aspirateur, **caractérisé en ce que** la carte de circuits imprimés (11) est séparée mécaniquement du dispositif de fixation (7) et est retenue sans contrainte au niveau des contacts électriques (10) du composant électrique (9).

2. Aspirateur selon la revendication 1, **caractérisé en ce que** le dispositif de fixation (7) comporte des crochets d'encliquetage (8) enserrant le composant électrique (9), par lesquels le composant électrique (9) est maintenu dans le dispositif de fixation (7).

3. Aspirateur selon la revendication 1 ou 2, **caractérisé en ce que** le dispositif de fixation (7) est prévu sur une partie (1) du boîtier de l'aspirateur.

4. Aspirateur selon la revendication 1 ou 2, **caractérisé en ce que** le dispositif de fixation (7) est prévu sur une structure de support (14) d'un touret de câble (5) logé dans le boîtier de l'aspirateur.

5. Aspirateur selon l'une des revendications précédentes, **caractérisé en ce que** la carte de circuits imprimés (11) est protégée, au moyen d'un support (13), contre un déplacement intempestif de la carte de circuits imprimés (11) hors du plan de la carte de circuits imprimés dans un sens de déplacement.

6. Aspirateur selon la revendication 5, **caractérisé en ce que** le support (13) est prévu à une extrémité de la carte de circuits imprimés (11) opposée au dispositif de fixation (7).

7. Aspirateur selon la revendication 5 ou 6, **caractérisé en ce que** le support (13) se présente sous la forme d'un crochet d'encliquetage (8) prévu sur le boîtier de l'aspirateur ou sur la structure de support (14) du touret de câble (5) et enserrant la carte de circuits imprimés (11).

## Claims

1. Vacuum cleaner with an actuating element (17) for an electrical component (9), which is fastened in a mount (7) in the vacuum cleaner and the electrical contacts (10) of which are mechanically fastened on a circuitboard (11) and are, for control of at least one function of the vacuum cleaner, connected with conductor tracks of the circuitboard (11) by electrical contact-making, **characterised in that** the circuitboard (11) is mounted, mechanically separately from the mount (7), without stress at the electrical contacts (10) of the electrical component (9).

2. Vacuum cleaner according to claim 1, **characterised in that** the mount (7) comprises detent hooks (8) which engage around the electrical component (9) and by which the electrical component (9) is held in the mount (7).

3. Vacuum cleaner according to claim 1 or 2, **characterised in that** the mount (7) is provided at a housing part (1) of the vacuum cleaner.

4. Vacuum cleaner according to claim 1 or 2, **characterised in that** the mount (7) is provided at a support structure (14) of a cable drum (5) mounted in the housing of the vacuum cleaner.

5. Vacuum cleaner according to any one of the preceding claims, **characterised in that t**he circuitboard (11) is secured by means of a support (13) against unintended movement of the circuitboard (11) in a movement direction out of the circuitboard plane.

6. Vacuum cleaner according to claim 5, **characterised in that** the support (13) is provided at an end of the circuitboard (11) opposite the mount (7).

7. Vacuum cleaner according to claim 5 or 6, **characterised in that** the support (13) is constructed as a detent hook (8) which is provided at the housing of the vacuum cleaner or at the support structure (14) of the cable drum (15) and which engages around the circuitboard (11).
